# EUROPEAN PATENT APPLICATION

(11) **EP 4 465 366 A1**
(43) Date of publication of application: **20.11.2024**
(21) Application number: 24719867.4
(22) Date of filing: 30.01.2024
(51) Int. Cl.: H01L 31/048, H01L 31/18, H01L 31/049

(54) **PHOTOVOLTAIC ASSEMBLY INTEGRATED STRUCTURE AND FORMING METHOD THEREFOR**

(30) Priority: 28.03.2023 CN 202310317313; 22.05.2023 CN 202310595770
(71) Applicant: Goodwe Power Technology (Guangde) Co., Ltd., Xuancheng, Anhui 242200 (CN)
(72) Inventor: WANG, Wulei, Xuancheng, Anhui 242200 (CN); XIA, Yuanfu, Xuancheng, Anhui 242200 (CN); WANG, Qingzhou, Xuancheng, Anhui 242200 (CN); WANG, Tao, Xuancheng, Anhui 242200 (CN); YAN, Jiahua, Xuancheng, Anhui 242200 (CN)
(74) Representative: HGF
(86) International application number: PCT/CN2024/074692
(87) International publication number: WO 2024/198697

(57) **Abstract**

The present application provides a photovoltaic module integral structure and a molding method. The photovoltaic module integral structure includes a photovoltaic module and a fixing assembly, the fixing assembly is connected to a bottom side of the photovoltaic module, the fixing assembly includes a waterproof roll sheet, a first photovoltaic backplate and a suturing member, the waterproof roll sheet and the first photovoltaic backplate are sutured and fixed by the suturing member, a side edge of the waterproof roll sheet protrudes out of a side edge of the first photovoltaic backplate, and the waterproof roll sheet is connected to the bottom side of the photovoltaic module; and the waterproof roll sheet is connected to the first photovoltaic backplate by setting the suturing member, the side edge of the waterproof roll sheet protrudes out of the side edge of the first photovoltaic backplate, and when the waterproof roll sheet is connected to the roofing roll sheet material, the side edge of the waterproof roll sheet is fixedly connected to the roofing roll sheet material in a hot-gas welding mode. Since the present application performs suturing and fixing on the waterproof roll sheet and the first photovoltaic backplate by the suturing member, suturing and fixing by the suturing member may improve stability of connection of the waterproof roll sheet and the first photovoltaic backplate, thus improving stability of connection of the photovoltaic module and the roofing roll sheet material.

## Description

### CROSS REFERENCE TO RELATED APPLICATIONS

The present application claims priority to the Chinese patent application No. 202310317313.9 filed on March 28, 2023 to the China Patent Office, and entitled "photovoltaic module integral structure and molding method", and priority to the Chinese patent application 202310595770.4 filed on May 22, 2023 to the China Patent Office, and entitled "photovoltaic module integral structure and molding method", the entire content of which is incorporated herein by reference.

### TECHNICAL FIELD

The present application relates to the technical field of photovoltaic products, in particular to a photovoltaic module integral structure and a molding method.

### BACKGROUND

At present, most of photovoltaic modules on the market adopt a structure of a polymer front plane, an adhesive film, a solar cell sheet, an adhesive film and a polymer backplate, and when the photovoltaic modules are connected to a roofing roll sheet material, most of the photovoltaic modules are bonded with the roofing roll sheet material directly by structural adhesive.

In the prior art, a photovoltaic module integral structure is disclosed, and includes a secondary waterproof roll sheet, a photovoltaic module integrated on a front of the secondary waterproof roll sheet, and a bonding layer arranged between the front of the secondary waterproof roll sheet and the photovoltaic module, and a hot-gas welding region is arranged on a back of the secondary waterproof roll sheet. The hot-gas welding region on the back of the secondary waterproof roll sheet and a front hot-gas welding region of a main waterproof roll sheet on a roofing structure are attached and perform hot-gas welding, so as to achieve fixing of the photovoltaic module and the roofing structure. Compared with structural adhesive bonding, hot-gas welding may improve stability of connection of the photovoltaic module.

However, for the above photovoltaic module integral structure, since when the secondary waterproof roll sheet and the photovoltaic module are packaged, insufficient bonding force will appear during bonding of the secondary waterproof roll sheet and the bonding layer, which makes reliability of the photovoltaic module fixing to the roofing structure by the secondary waterproof roof have certain risks.

### SUMMARY OF THE INVENTION

Therefore, the present application aims to solve technical problems that for the photovoltaic module integral structure in the prior art, since when the secondary waterproof roll sheet and the photovoltaic module are packaged, insufficient bonding force will appear during bonding of the secondary waterproof roll sheet and the bonding layer, which makes reliability of the photovoltaic module fixing to the roofing structure by the secondary waterproof roof have certain risks.

Therefore, the present application provides a photovoltaic module integral structure, including:
a photovoltaic module; and
a fixing assembly, connected to a bottom side of the photovoltaic module;
wherein the fixing assembly includes a waterproof roll sheet, a first photovoltaic backplate and a suturing member, the waterproof roll sheet and the first photovoltaic backplate are sutured and fixed together by the suturing member, a side edge of the waterproof roll sheet protrudes out of a side edge of the first photovoltaic backplate, and the waterproof roll sheet is connected to the bottom side of the photovoltaic module.

Optionally, the waterproof roll sheet includes:
a first waterproof roll sheet, sutured and fixed to one side of the first photovoltaic backplate by the suturing member; and
a second waterproof roll sheet, sutured and fixed to another side of the first photovoltaic backplate by the suturing member, wherein side edges of the first waterproof roll sheet and the second waterproof roll sheet both protrude out of the side edge of the first photovoltaic backplate.

Optionally, the first waterproof roll sheet and the second waterproof roll sheet are arranged on two opposite sides of the first photovoltaic backplate.

Optionally, the first waterproof roll sheet and the second waterproof roll sheet are each provided with a plurality of through holes, and a first photovoltaic adhesive film is sutured and fixed between the waterproof roll sheet and the first photovoltaic backplate.

Optionally, the first photovoltaic adhesive film and the first photovoltaic backplate completely cover a bottom of the photovoltaic module, or
the first photovoltaic adhesive film and the first photovoltaic backplate partially cover a bottom of the photovoltaic module, and the first photovoltaic adhesive film completely covers the waterproof roll sheet.

Optionally, film plates are arranged on a side of the first photovoltaic backplate away from the waterproof roll sheet, and the film plates are arranged in a suturing region of the suturing member, so as to shield the suturing member.

Optionally, the suturing member is a suture line, and the suture line is a polymer wire or a glass fiber wire.

Optionally, the waterproof roll sheet is made of a polymer roofing roll sheet material.

Optionally, the photovoltaic module includes photovoltaic glass, a second photovoltaic adhesive film, a cell sheet, a third photovoltaic adhesive film and a second photovoltaic backplate, and a fourth photovoltaic adhesive film is arranged between the second photovoltaic backplate and the fixing assembly.

A molding method is used for molding the above photovoltaic module integral structure and includes the following steps:
laying a photovoltaic module: sequentially laying photovoltaic glass, a second photovoltaic adhesive film, a cell sheet, a third photovoltaic adhesive film and a second photovoltaic backplate in the photovoltaic module;
laying a fixing assembly: sequentially stacking a waterproof roll sheet, a first photovoltaic adhesive film and a first photovoltaic backplate in the fixing assembly, and suturing and fixing the waterproof roll sheet, the first photovoltaic adhesive film and the first photovoltaic backplate together by using a suturing member;
performing integral laying: placing a fourth photovoltaic adhesive film between the second photovoltaic backplate on a bottom side of the photovoltaic module and the waterproof roll sheet on an upper side of the fixing assembly, and arranging film plates on the first photovoltaic backplate in a suturing region of the suturing member on a bottom side of the fixing assembly; and
performing integral molding: placing the laid photovoltaic module and the laid fixing assembly into a laminating device at the same time and performing one-time packaging molding.

The photovoltaic module integral structure and the molding method provided by the present application have the following advantages:
1. the present application provides the photovoltaic module integral structure, including the photovoltaic module and the fixing assembly, the fixing assembly being connected to the bottom side of the photovoltaic module, wherein the fixing assembly includes the waterproof roll sheet, the first photovoltaic backplate and the suturing member, the waterproof roll sheet and the first photovoltaic backplate are sutured and fixed by the suturing member, the side edge of the waterproof roll sheet protrudes out of the side edge of the first photovoltaic backplate, and the waterproof roll sheet is connected to the bottom side of the photovoltaic module.

According to the photovoltaic module integral structure of the structure, the suturing member is arranged to connect the waterproof roll sheet to the first photovoltaic backplate, the side edge of the waterproof roll sheet protrudes out of the side edge of the first photovoltaic backplate, when the waterproof roll sheet is connected to the roofing roll sheet material, the side edge, protruding out of the first photovoltaic backplate, of the waterproof roll sheet is fixedly connected to the roofing roll sheet material by structural adhesive or in a hot-gas welding mode, and since the present application performs suturing and fixing on the waterproof roll sheet and the first photovoltaic backplate by the suturing member, compared with the prior art that a photovoltaic adhesive film is merely adopted to fix a waterproof roll sheet, suturing and fixing of the suturing member may improve stability of the connection of the waterproof roll sheet and the first photovoltaic backplate, and then stability of the connection of the photovoltaic module and the roofing roll sheet material is improved.

2. The present application provides the photovoltaic module integral structure, the first waterproof roll sheet and the second waterproof roll sheet are each provided with a column of through holes arranged in a length direction, when high-temperature lamination is performed on the photovoltaic module integral structure, the through holes will be filled with the melted first photovoltaic adhesive film and the melted fourth photovoltaic adhesive film, and after curing, the first waterproof roll sheet and the second waterproof roll sheet may more reliably connect to structure layers on an upper side and a lower side of the structure.

3. The present application provides the photovoltaic module integral structure, and a line suturing technology belongs to a mechanical connection measure, which avoids the problem of unreliable bonding force caused by different brands and different materials, and greatly improves the adaptability of the module and the polymer waterproof roll sheet.

4. The present application provides the photovoltaic module integral structure, a dual-layer backplate is adopted on a back of the photovoltaic module, back strength of the module is improved, whole safety performance of the module is improved, and a risk of subfissure of the cell sheet due to back impact is greatly reduced.

### BRIEF DESCRIPTION OF THE DRAWINGS

In order to more clearly explain specific implementations of the present application or technical solutions in the prior art, accompanying drawings required to be used in the description of the specific implementations or the prior art are briefly introduced below. Obviously, the accompanying drawings in the following description are some implementations of the present application. Those ordinarily skilled in the art may obtain other accompanying drawings according to these accompanying drawings without any creative labor.
FIG. 1 is a front view of a photovoltaic module integral structure provided by an embodiment of the present application.
FIG. 2 is an explosive view of a photovoltaic module integral structure provided by an embodiment of the present application.
FIG. 3 is a positional relation diagram of a photovoltaic module integral structure provided by an embodiment of the present application.
FIG. 4 is an enlarged diagram of a local structure in FIG. 3.
FIG. 5 is a schematic structural diagram of a waterproof roll sheet in a photovoltaic module integral structure provided by an embodiment of the present application.

Accompanying drawing reference signs are illustrated:
1-photovoltaic glass; 2-second photovoltaic adhesive film; 3-cell sheet; 4-third photovoltaic adhesive film; 5-second photovoltaic backplate; 6-fourth photovoltaic adhesive film; 7-waterproof roll sheet; 8-first photovoltaic adhesive film; 9-first photovoltaic backplate; 10-film plate; and 11-suturing member.

### DETAILED DESCRIPTION

The technical solution of the present application will be clearly and completely described in combination with accompanying drawings below. Obviously, embodiments described are part of the embodiments of the present application, not all the embodiments. All other embodiments obtained by those ordinarily skilled in the art based on the embodiments of the present application without creative labor all fall within the scope of protection of the present application.

In the description of the present application, it should be noted that an orientation or position relationship indicated by terms "center", "up", "down", "left", "right", "vertical", "horizontal", "inside", "outside", etc. is based on an orientation or position relationship shown based on the accompanying drawings and is only for the purpose of facilitating the description of the present application and simplifying the description, rather than indicating or implying that an apparatus or element referred to must have a particular orientation, and be constructed and operated in a particular orientation, so that it is not to be construed as a limitation of the present application. In addition, terms "first", "second", and "third" are only used for descriptive purposes and are not understood to indicate or imply relative importance. In addition, technical features involved in different implementations of the present application described below may be combined with each other as long as they do not conflict with each other.

### Embodiment 1

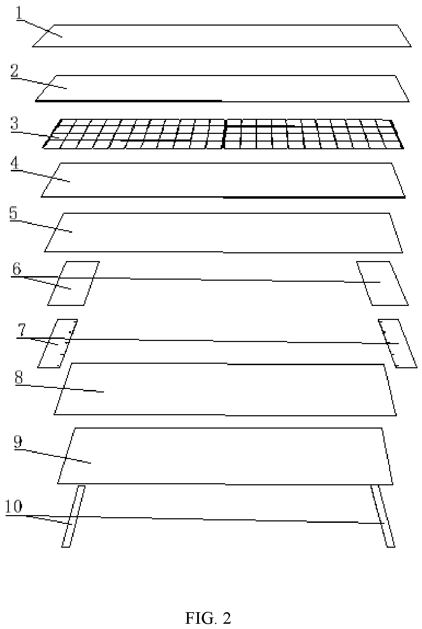

The present embodiment provides a photovoltaic module integral structure, including a photovoltaic module and a fixing assembly, as shown in FIG. 2, the photovoltaic module includes photovoltaic glass 1, a second photovoltaic adhesive film 2, a cell sheet 3, a third photovoltaic adhesive film 4 and a second photovoltaic backplate 5 sequentially from top to bottom; the fixing assembly includes a waterproof roll sheet 7, a first photovoltaic adhesive film 8, a first photovoltaic backplate 9 and film plates 10 sequentially from top to bottom, and the waterproof roll sheet 7, the first photovoltaic adhesive film 8 and the first photovoltaic backplate 9 perform suturing and fixing on the photovoltaic module by a suturing member 11; and the second photovoltaic backplate 5 on a bottom side of the photovoltaic module and the waterproof roll sheet 7 on an upper side of the fixing assembly are fixed by a fourth photovoltaic adhesive film 6. The photovoltaic module is a flexible or light photovoltaic module.

In the present embodiment, as shown in FIG. 2, the waterproof roll sheet 7 includes a first waterproof roll sheet and a second waterproof roll sheet, the first waterproof roll sheet is sutured and fixed on upper surfaces of left sides of the first photovoltaic adhesive film 8 and the first photovoltaic backplate 9 by the suturing member 11, and the second waterproof roll sheet is sutured and fixed on upper surfaces of right sides of the first photovoltaic adhesive film 8 and the first photovoltaic backplate 9 by the suturing member 11. The suturing member 11 is a suture line, the suture line is a polymer wire such as ultra-high molecular weight polyethylene, the suture line may also be a glass fiber wire, etc., and a material of the waterproof roll sheet 7 is thermoplastic polyolefin (TPO), polyvinyl chloride (PVC), ethylene propylene diene monomer (EPDM), and other common roofing roll sheet materials, and may also be other polymer roofing roll sheet materials.

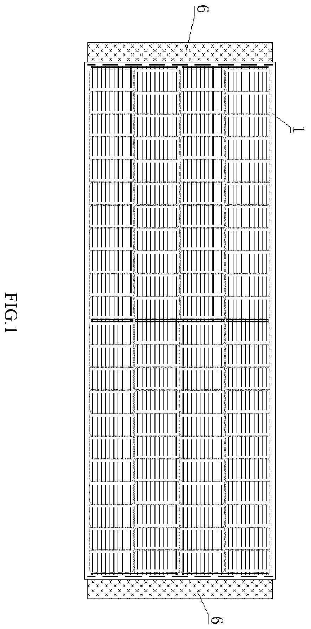

Furthermore, as shown in FIG. 1, FIG. 3 and FIG. 4, a portion of a left edge of the first waterproof roll sheet protrudes out of left sides of the first photovoltaic adhesive film 8 and the first photovoltaic backplate 9, and at the same time, a portion of a right edge of the second waterproof roll sheet protrudes out of right sides of the first photovoltaic adhesive film 8 and the first photovoltaic backplate 9.

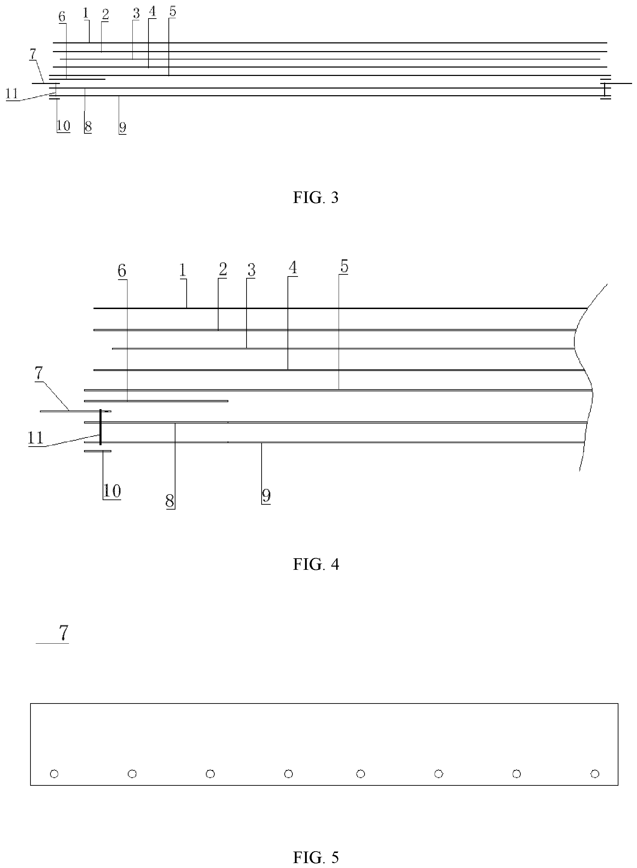

Furthermore, as shown in FIG. 2 and FIG. 5, the first waterproof roll sheet and the second waterproof roll sheet are each provided with a column of through holes arranged in a length direction, when high-temperature lamination is performed on the photovoltaic module integral structure, the through holes will be filled with the melted first photovoltaic adhesive film 8 and the melted fourth photovoltaic adhesive film 6, and after curing, the first waterproof roll sheet and the second waterproof roll sheet may more reliably connect to structure layers on an upper side and a lower side of the structure.

It may be understood that in some other implementations, the through holes may also be formed in other portions of surfaces of the first waterproof roll sheet and the second waterproof roll sheet, and the above effect may also be implemented.

When the photovoltaic module integral structure provided by the present embodiment is connected to the roofing roll sheet material, a left side of the first waterproof roll sheet protrudes out of edge portions of the first photovoltaic adhesive film 8 and the first photovoltaic backplate 9, a right side of the second waterproof roll sheet protrudes out of edge portions of the first photovoltaic adhesive film 8 and the first photovoltaic backplate 9, and the two portions are each fixedly connected to the roofing roll sheet material through structural adhesive or in a hot-gas welding mode. Since the present embodiment sutures and fixes the first waterproof roll sheet and the second waterproof roll sheet to the first photovoltaic adhesive film 8 and the first photovoltaic backplate 9 by the suturing member 11, compared with the prior art that only a photovoltaic film is adopted to fix the waterproof roll sheet 7, suturing and fixing of the suturing member 11 may improve stability of connection of the waterproof roll sheet 7 with the first photovoltaic adhesive film 8 and the first photovoltaic backplate 9, and then improve stability of connection of the photovoltaic module and the roofing roll sheet material.

Meanwhile, as bonding force of polymer waterproof roll sheet products of different manufacturers is different, more seriously, bonding force of a PVC polymer waterproof roll sheet and a photovoltaic adhesive film is weaker, as a result, a category of selectable polymer waterproof roll sheets is limited, and there is a certain risk of reliability. In the present embodiment, a line suturing technology belongs to a mechanical connection measure, which avoids the problem of unreliable bonding force caused by different brands and different materials, and greatly improves the adaptability of the module and the polymer waterproof roll sheet.

In the present embodiment, as shown in FIG. 2 and FIG. 3, an area of the first photovoltaic adhesive film 8 is equal to an area of the first photovoltaic backplate 9, so that when the first photovoltaic adhesive film 8 and the first photovoltaic backplate 9 are bonded, the first photovoltaic adhesive film 8 and the first photovoltaic backplate 9 may be completely covered; and the area of the photovoltaic adhesive film 8 is also equal to an area of the second photovoltaic backplate 5 in the photovoltaic module, so that the photovoltaic adhesive film 8 may completely cover the second photovoltaic backplate 5.

In some other implementations, the first photovoltaic adhesive film 8 and the first photovoltaic backplate 9 may also be set as a left portion and a right portion, and respectively cover regions provided with the first waterproof roll sheet and the second waterproof roll sheet of the second photovoltaic backplate 5.

In the present embodiment, as shown in FIG. 2, the number of the film plates 10 is two, the film plates 10 are white adhesive film plates, the white adhesive film plates are made of fluorinated polymer materials, such as kraft paper fiber (KPF), kraft paper coated (KPC), composite paper cement (CPC) and other materials, and the film plates 10 are arranged in the suturing region of the suturing member 11 at the bottom of the first photovoltaic backplate 9. Since the film plates are white and light-proof, the film plates 10 may be used for shielding the suturing region of the suturing member 11, which ensures that the module after lamination is complete and attractive.

According to the photovoltaic module integral structure provided by the present embodiment, when the photovoltaic module is laid, the photovoltaic glass 1, the second photovoltaic adhesive film 2, the cell sheet 3, the third photovoltaic adhesive film 4 and the second photovoltaic backplate 5 are arranged sequentially from top to bottom; when the fixing assembly is laid, the waterproof roll sheet 7, the first photovoltaic adhesive film 8, the first photovoltaic backplate 9 and the film plates 10 are arranged sequentially from top to bottom, the waterproof roll sheet 7, the first photovoltaic adhesive film 8 and the first photovoltaic backplate 9 are sutured and fixed by the suturing member 11, meanwhile, the fourth photovoltaic adhesive film 6 is placed between the second photovoltaic backplate 5 on the bottom side of the photovoltaic module and the waterproof roll sheet 7 on the upper side of the fixing assembly, the film plates 10 are arranged on the first photovoltaic backplate in the suturing region of the suturing member 11 on the bottom side of the fixing assembly, then the fixed photovoltaic module and the fixed fixing assembly are placed into a laminating device at the same time, and one-time packaging molding is performed.

When the photovoltaic module integral structure is connected to the roofing roll sheet material, a left side of the first waterproof roll sheet protrudes out of edge portions of the first photovoltaic adhesive film 8 and the first photovoltaic backplate 9, a right side of the second waterproof roll sheet protrudes out of the edge portions of the first photovoltaic adhesive film 8 and the first photovoltaic backplate 9, and the two portions are both fixedly connected to the roofing roll sheet material by the structural adhesive or in a hot-gas welding mode.

According to the photovoltaic module integral structure provided by the present embodiment, force, required when the photovoltaic module is stripped from the roofing roll sheet, measured by a tension meter is shown in the following table:

**Table 1 various parameters measured by the tension meter**

| | Suturing member material | Striping force (N) |
|---|---|---|
| Experimental example | Nylon wire | 103.2 |
| | Nylon wire | 62.66 |
| | Polymer wire | 100.7 |
| | Polymer wire | 72.86 |
| Comparison example | No (adopting bonding) | 26.5 |

Table 1 summarizes the force, required when the photovoltaic module is stripped from the roofing roll sheet, measured by the tension meter. It may be seen that the photovoltaic module integral structure of the present embodiment adopts the suturing member to suture the waterproof roll sheet 7, and compared with the prior art that the photovoltaic adhesive film is adopted to fix the waterproof roll sheet 7, the photovoltaic module integral structure of the present embodiment may improve the stability of the connection of the photovoltaic module and the roofing waterproof roll sheet.

### Embodiment 2

The present embodiment provides a molding method, and the molding method is used for molding the photovoltaic module integral structure provided in the embodiment 1 and includes the following steps:
a photovoltaic module is laid: photovoltaic glass 1, a second photovoltaic adhesive film 2, a cell sheet 3, a third photovoltaic adhesive film 4 and a second photovoltaic backplate 5 in the photovoltaic module are laid sequentially;
a fixing assembly is laid: a waterproof roll sheet 7, a first photovoltaic adhesive film 8 and a first photovoltaic backplate 9 in the fixing assembly are sequentially stacked, and are sutured and fixed together by using a suturing member 11;
integral laying is performed: a fourth photovoltaic adhesive film 6 is placed between a second photovoltaic backplate 5 on a bottom side of the photovoltaic module and the waterproof roll sheet 7 on an upper side of the fixing assembly, and film plates 10 are arranged on the first photovoltaic backplate 9 in a suturing region of the suturing member 11 on a bottom side of the fixing assembly; and
integral molding is performed: the laid photovoltaic module and the laid fixing assembly are placed into a laminating device at the same time, and one-time packaging molding is performed.

In the present embodiment, a sequence of laying the photovoltaic module and a sequence of laying the fixing assembly may be exchanged.

Obviously, the above embodiments are only examples for clear illustration and are not a limitation on the implementation. For those ordinarily skilled in the art, other changes or variations in different forms may be made on the basis of the above description. It is not necessary and cannot be exhaustive for all implementations here. Apparent changes or variations derived therefrom still fall within the scope of protection of the present application.

## Claims

1. A photovoltaic module integral structure, comprising:
a photovoltaic module; and
a fixing assembly connected to a bottom side of the photovoltaic module;
wherein the fixing assembly comprises a waterproof roll sheet, a first photovoltaic backplate and a suturing member, the waterproof roll sheet and the first photovoltaic backplate are sutured and fixed together by the suturing member, a side edge of the waterproof roll sheet protrudes out of a side edge of the first photovoltaic backplate, and the waterproof roll sheet is connected to the bottom side of the photovoltaic module.

2. The photovoltaic module integral structure according to claim 1, wherein the waterproof roll sheet comprises:
a first waterproof roll sheet, sutured and fixed to one side of the first photovoltaic backplate by the suturing member; and
a second waterproof roll sheet, sutured and fixed to another side of the first photovoltaic backplate by the suturing member, wherein side edges of the first waterproof roll sheet and the second waterproof roll sheet both protrude out of the side edges of the first photovoltaic backplate.

3. The photovoltaic module integral structure according to claim 2, wherein the first waterproof roll sheet and the second waterproof roll sheet are arranged on two opposite sides of the first photovoltaic backplate.

4. The photovoltaic module integral structure according to claim 3, wherein the first waterproof roll sheet and the second waterproof roll sheet are each provided with a plurality of through holes, and a first photovoltaic adhesive film is sutured and fixed between the waterproof roll sheet and the first photovoltaic backplate.

5. The photovoltaic module integral structure according to claim 4, wherein the first photovoltaic adhesive film and the first photovoltaic backplate completely cover a bottom of the photovoltaic module, or
the first photovoltaic adhesive film and the first photovoltaic backplate partially cover a bottom of the photovoltaic module, and the first photovoltaic adhesive film completely covers the waterproof roll sheet.

6. The photovoltaic module integral structure according to claim 4, wherein film plates are arranged on a side of the first photovoltaic backplate away from the waterproof roll sheet, and the film plates are arranged in a suturing region of the suturing member, so as to shield the suturing member.

7. The photovoltaic module integral structure according to claim 6, wherein the suturing member is a suture line, and the suture line is a polymer wire or a glass fiber wire.

8. The photovoltaic module integral structure according to claim 6, wherein the waterproof roll sheet is made of a polymer roofing roll sheet material.

9. The photovoltaic module integral structure according to claim 1, wherein the photovoltaic module comprises photovoltaic glass, a second photovoltaic adhesive film, a cell sheet, a third photovoltaic adhesive film and a second photovoltaic backplate, and a fourth photovoltaic adhesive film is arranged between the second photovoltaic backplate and the fixing assembly.

10. A molding method, for molding the photovoltaic module integral structure according to any one of claims 1 to 9, and comprising the following steps:
laying a photovoltaic module: sequentially laying photovoltaic glass, a second photovoltaic adhesive film, a cell sheet, a third photovoltaic adhesive film and a second photovoltaic backplate in the photovoltaic module;
laying a fixing assembly: sequentially stacking a waterproof roll sheet, a first photovoltaic adhesive film and a first photovoltaic backplate in the fixing assembly, and suturing and fixing the waterproof roll sheet, the first photovoltaic adhesive film and the first photovoltaic backplate by using a suturing member;
performing integral laying: placing a fourth photovoltaic adhesive film between the second photovoltaic backplate on a bottom side of the photovoltaic module and the waterproof roll sheet on an upper side of the fixing assembly, and arranging film plates on the first photovoltaic backplate in a suturing region of the suturing member on a bottom side of the fixing assembly; and
performing integral molding: placing the laid photovoltaic module and the laid fixing assembly into a laminating device at the same time and performing one-time packaging molding.
